(19) Europäisches Patentamt
European Patent Office
Office européen des brevets

(11) **EP 1 786 031 A1**

(12) **EUROPEAN PATENT APPLICATION**

(43) Date of publication:
**16.05.2007 Bulletin 2007/20**

(51) Int Cl.:
*H01L 21/336* (2006.01)   *H01L 29/78* (2006.01)
*H01L 29/423* (2006.01)   *H01L 21/28* (2006.01)

(21) Application number: **05110577.3**

(22) Date of filing: **10.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(71) Applicant: **STMicroelectronics S.r.l.**
**20041 Agrate Brianza (Milano) (IT)**

(72) Inventors:
• **Annese, Marco**
**I-20060, VIGNATE (MI) (IT)**

• **Toia, Fabrizio Fausto**
**I-21052, BUSTO ARSIZIO (VA) (IT)**
• **Montanini, Pietro**
**I-20144, MILANO (IT)**

(74) Representative: **Pezzoli, Ennio et al**
**Maccalli & Pezzoli S.r.l.**
**Via Settembrini 40**
**20124 Milano (IT)**

(54) **Vertical-gate mos transistor for high voltage applications with variable gate oxide thickness**

(57) A vertical-gate MOS transistor (**100**) is proposed. The vertical-gate MOS transistor is integrated in a semiconductor chip (**120**) of a first conductivity type having a main surface, and includes an insulated trench gate (**110**) extending into the semiconductor chip from the main surface to a gate depth (**d1**), said trench gate including a control gate (**G**) and an insulation layer (**180**) for insulating the control gate from the semiconductor chip, a source region and a drain region of a second conductivity type formed in the semiconductor chip, at least one of the source region and drain region being adjacent to the insulation layer and extending into the semiconductor chip from the main surface to a region depth (**d2**) lower than the gate depth, wherein the insulation layer includes an external portion (**180a**), extending into the semiconductor chip from the main surface to a protection depth (**d4**) lower than the gate depth, and a remaining internal portion (**180b**), the external portion having an external thickness (**d5**) and the internal portion having an internal thickness (**d6**) lower than the external thickness.

FIG.1

EP 1 786 031 A1

**Description**

Field of the invention

The present invention generally relates to semiconductor devices.

More specifically, the invention relates to vertical-gate MOS transistors.

Background art

In the last years, the demand of increasing the semiconductor device integration density has brought to reduce the size of the elements used in integrated circuits.

A basic integrated circuit element is the transistor; particularly, in high-density integrated circuits, field-effect transistors are used. The use of integrated transistors in a number of relatively high power applications, such as liquid crystal display drivers and the like, has made it necessary to manufacture small size transistors that are nevertheless able to withstand relatively high voltages (for example, 10V-70V). Limitations in the manufacturing of small size field-effect transistors (for example, of the MOS type) often arise from the length of the transistor channel, *i.e.,* the region between the source and drain regions.

A well-defined channel length is important for the correct operation of the MOS transistor; in fact, many electrical characteristic parameters, such as the transconductance, depend on the transistor channel length.

Moreover, as the channel length becomes smaller, the correct operation of the transistor as a whole may be impaired, due for example to short-channel effects, such as punch-through phenomena or a permanently short-circuited channel.

In particular, as far as MOS transistors for relatively high power applications are concerned, further electrical characteristic parameters that make the manufacturing of a small size MOS transistor troublesome are the voltages that it can withstand at its *PN* junctions and gate oxide layer; in particular, in order for the MOS transistor to withstand the desired high voltages, these must be lower than the breakdown voltages of both the *PN* junctions and the gate oxide layer.

As known, the breakdown voltage of the *PN* junction depends on a certain number of design and manufacturing process parameters, such as the dopant concentration of the regions forming the *PN* junction and the width of such regions. Particularly, the lower the dopant concentration of the regions forming the *PN* junction is the higher the breakdown voltage is. Moreover, in the case one or both of the regions forming the *PN* junction are lightly doped, the width of such regions must be enough to permit the extent of the depletion area in reverse bias condition, and this limits the possibility of reducing the integrated circuit area.

Likewise, the breakdown voltage of the gate oxide layer depends on a certain number of manufacturing process parameters, such as the thickness of such oxide layer. As known, the higher the thickness of the gate oxide layer is the higher the voltage withstood by the MOS transistor is. However, a higher thickness of the gate oxide layer reduces the saturation current of the MOS transistor. Thus, the thickness of such oxide layer should be kept relatively low, thereby reducing the voltages that can be withstood by the MOS transistor.

Vertical-gate MOS transistors (also known in the art as V-MOS, U-MOS, folded gate or trench gate MOS transistors) are less affected by short channel effects. In these devices, a trench is formed in a substrate region of a chip of semiconductor material wherein the MOS transistor is integrated. The walls of the trench are covered with a gate oxide layer, and the trench is then filled with a conductive material (typically, a polycrystalline silicon layer) adapted to form the gate electrode. The source and drain regions of the MOS transistor are formed in the chip at opposite sides of the trench.

This MOS transistor has a channel region developing along the vertical and bottom walls of the trench, between the source and drain regions. In such a way, even if the overall size of the vertical-gate MOS transistor is reduced, the channel region can be kept sufficiently long to prevent the short channel effects.

A vertical-gate MOS transistor is disclosed in the US patent 4,455,740, which also describes a related manufacturing method.

The Applicant has observed that a vertical-gate MOS transistor realized according to the teachings of that patent is not able to withstand high voltages across the substrate-drain and substrate-source junctions, due to the fact that the drain and source regions are heavily doped ($N^+$) diffusion layers. The high dopant concentration of the drain and source regions reduces the substrate-source and substrate-drain junctions breakdown voltages, and thus the voltages that can be withstood by such *PN* junctions. Moreover, the gate oxide layer is not able to sustain high voltages, due to its thin thickness. Both these features make the MOS transistor not particularly adapted for power applications.

The US patent 6,586,800 proposes a different vertical-gate MOS transistor wherein the drain region consists of a layer buried in the chip under the channel. The drain current is collected through a metallization formed at the bottom surface of the chip.

As an alternative to the bottom surface drain contact, a top-surface sinker adapted to collect the drain current may be provided, for example, as described in the U.S. patent 5,124,764.

In both the solutions, the dopant concentration of the drain region (but not of the source region) is chosen according to the desired breakdown voltage of the drain-substrate junction.

As a result, the breakdown voltages are relatively high for the substrate-drain junction, but low for the substrate-source junction. Thus, the proposed MOS transistor is inherently asymmetric; this may be a disadvantage, because in many applications (e.g., pass transistors) the source and drain regions should be interchangeable.

In any case, the thin gate oxide layer does not allow withstanding high voltages supplied between the gate and drain/source terminals of the MOS transistor.

Summary of the invention

The present invention provides a solution as set out in the independent claims. Advantageous embodiments of the invention are provided in the dependent claims.

In principle, according to the present invention, the idea is suggested of providing a trench gate structure with an insulation layer having a differentiated thickness.

Particularly, an aspect of the present invention proposes a vertical-gate MOS transistor. The vertical-gate MOS transistor is integrated in a semiconductor chip of a first conductivity type having a main surface. An insulated trench gate extends into the semiconductor chip from the main surface to a gate depth. The trench gate includes a control gate and an insulation layer (for insulating the control gate from the semiconductor chip). A source region and a drain region of a second conductivity type are formed in the semiconductor chip; one or both of the source region and drain region are adjacent to the insulation layer and extends into the semiconductor chip from the main surface to a region depth (lower than the gate depth). The insulation layer includes an external portion (extending into the semiconductor chip from the main surface to a protection depth lower than the gate depth) and a remaining internal portion. The external portion has an external thickness and the internal portion has an internal thickness lower than the external thickness.

Another aspect of the present invention proposes a corresponding method for manufacturing a vertical-gate MOS transistor.

Brief description of the drawings

The present invention, as well as further features and the advantages thereof, will be best understood by reference to the following detailed description, given purely by way of a non-restrictive indication, to be read in conjunction with the accompanying drawings, wherein:

> **Figure 1** schematically shows a cross-sectional view of a MOS transistor according to an embodiment of the present invention;
> **Figure 2** shows an exemplificative diagram relating to electrical operative parameters of the MOS transistor according to an embodiment of the present invention;
> **Figures 3A** through **3N** are cross-sectional views illustrating the main steps of the manufacturing of the MOS transistor, according to an embodiment of the present invention;
**Figure 4** shows exemplificative dopant concentration profiles through the drain and source regions of the MOS transistor, according to an embodiment of the present invention;
**Figure 5** shows illustrative diagrams explaining the operation of the MOS transistor, according to an embodiment of the present invention; and
**Figure 6** shows further exemplificative diagrams explaining the operation of the MOS transistor, according to an embodiment of the present invention.

Detailed description

In the following description, it should be noted that the Figures are not drawn to scale. Relative dimensions and proportions of parts of drawings have been increased or reduced in size for the sake of clarity.

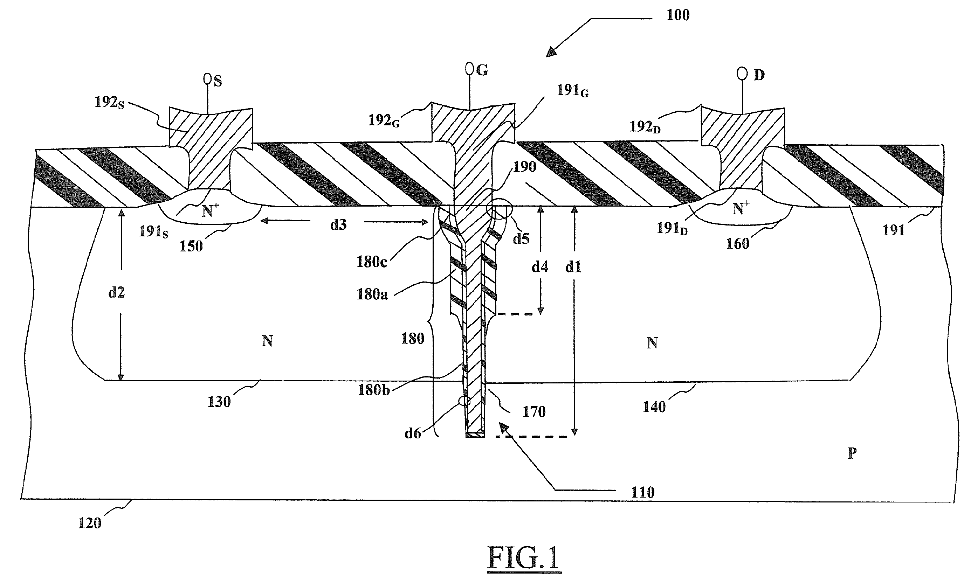

Referring to **Figure 1,** a cross-sectional view of a vertical-gate MOS transistor **100** according to an embodiment of the present invention is shown. The MOS transistor **100** includes an insulated trench gate **110** which extends into a semiconductor region **120** *(i.e.,* the chip wherein the MOS transistor **100** is integrated) of a first type of conductivity (for example, P-type); the trench gate **110** reaches a (gate) depth **d1** with respect to a main surface of the semiconductor region **120.** At opposite sides of the trench gate **110,** (internal) operative source and drain regions **130** and **140** of a second type of conductivity, opposite to the first one (for example, *N*-type), extend from the main surface of the semiconductor region **120** to a (region) depth **d2.** Two (external) contact regions **150** and **160** of the N⁺ type of conductivity are formed in the regions **130** and **140,** respectively, at a distance **d3 (d3>0)** from the trench gate **110.**

The trench gate **110** is formed into a trench **170** excavated in the semiconductor region 120 from its main surface, and it includes an insulation layer **180** and a polycrystalline silicon layer **190.** The insulation layer **180** has an external portion **180a,** covering the walls of the trench **170** from the main surface of the semiconductor region **120** to a (protection) depth **d4,** and a remaining internal portion **180b,** covering the deep walls of the trench **170.** The external portion **180a** includes an edge section **180c** extending from the main surface of the semiconductor region **120** and which is inclined outwardly with respect to a remaining section of the external portion **180a.** For example, the edge section **180c** is inclined at an angle preferably ranging from 30° to 45°, and more preferably from 35° to 40° (for example, 37°). Typically, the depth of the edge section **180c** ranges from 10% to 20% and more preferably from 11% and 15% (for example, 13%) of the depth of the whole external portion **180a.** The external portion **180a** and the internal portion **180b** have respective (external and internal) thicknesses **d5** and **d6.** The polycrystalline silicon layer **190** fills the trench **170** so covered by the insulation layer **180.**

A field oxide layer **191** covers the main surface of the semiconductor region **120,** exception made for two active area windows **191$_S$** and **191$_D$** over the contact regions **150** and **160,** respectively, (where source and drain contacts are realized) and a window **191$_G$** over the free surface of polycrystalline silicon layer **190** (where the gate contact is realized). Metallizations **192$_S$, 192$_G$,** and **192$_D$** fill the windows **191$_S$, 191$_G$, 191$_D$** and form the source, gate, and drain terminals **S, G** and **D,** respectively, of the MOS transistor **100.**

In the MOS transistor **100,** a channel region is formed by a portion of the semiconductor region **120** between the internal source region **130** and the internal drain region **140,** which channel develops along the vertical and bottom walls of the insulated trench gate **110.** The MOS transistor **100** thus has a vertical-gate structure, which allows achieving a relatively high channel length at the same time saving integrated circuit area. In particular, it is possible to shrink the lateral dimension of the MOS transistor **100,** without for this reason incurring in short-channel effects (because the channel length can be increased by increasing the depth **d1** of the trench gate **110).**

The insulation layer **180** has the internal portion **180b** with the thickness **d6** that is lower than the thickness **d5** of the external portion **180a.** Preferably, the thickness **d6** ranges from 15% to 40% and more preferably from 20% to 30% (such as about 25%) of the thickness d5. For example, the thickness **d6** is about 90 nm and the thickness **d5** is about 350 nm.

The presence of the thin internal portion **180b** (adapted to be a gate oxide) along the walls of the trench **170** adjacent to the channel ensures a high saturation current of the MOS transistor **100.** In fact, as mentioned above, the lower the thickness **d6** of the internal portion **180b** is the higher the saturation current of the MOS transistor 100 is.

On the other hand, the thick external portion **180a** is able to sustain higher voltages before breaking. In such a way, the voltage which can be withstood by the MOS transistor **100** (i.e., between the gate terminal **G** and the drain/source terminals S/D) without breaking the insulation layer **180** is increased.

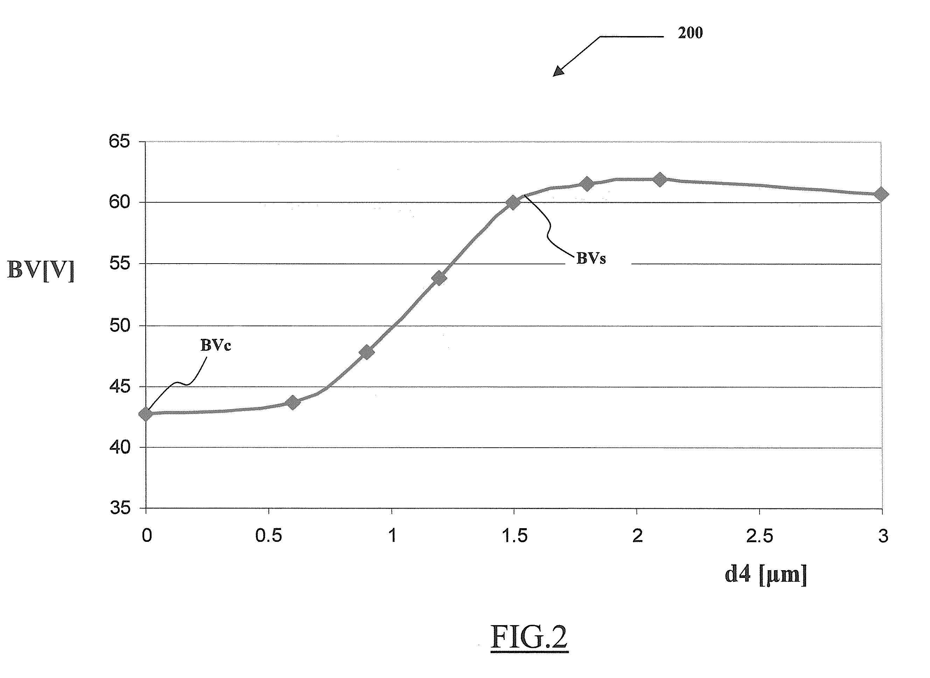

The depth **d4** of the external portion **180a** is lower than the depth **d2** of the source and drain regions **130, 140** (and then lower than the depth **d1** of the trench gate **110).** Preferably, the depth **d4** ranges from 20% to 60% and more preferably from 30% to 50% (such as 35%) of the depth **d1.** For example, the depth **d1** is 3.6$\mu$m, the depth **d2** is about 2.4$\mu$m and the depth **d4** ranges from 1.5$\mu$m to 1.8$\mu$m (such as 1.5$\mu$m). In such a way, as better described with reference to **Figure 2,** the overall performance of the MOS transistor **100** is improved when it is reverse biased.

Moreover, the fact that the contact regions **150** and **160** are spaced apart (at the distance **d3)** from the trench gate **110** further reduces the stress voltage at the insulation layer **180.** In fact, the voltage that is applied to the insulation layer **180** is reduced by an amount equal to the voltage drop at the portion of the semiconductor region 120 extending horizontally along the distance **d3.** Preferably, the distance **d3** ranges from 0.3$\mu$m to 2$\mu$m according to the requested breakdown voltage, and more preferably from 0.5$\mu$m to 1.5$\mu$m. For example, the distance **d3** is about 1$\mu$m.

The internal source region **130** and the internal drain region **140** are relatively lightly doped; for example, they have a dopant concentration preferably ranging from $1*10^{15}$ ions/cm$^3$ to $1*10^{17}$ ions/cm$^3$, and more preferably from $5*10^{15}$ ions/cm$^3$ to $5*10^{16}$ ions/cm$^3$ (such as about $1*10^{16}$ ions/cm$^3$). Thus, a breakdown voltage of the junctions between the source/drain regions **130, 140** and the semiconductor region **120** is kept relatively high; in this way the vertical-gate MOS transistor **100** is capable of withstanding high voltages.

The contact regions **150** and **160** are instead heavily doped; for example, they have a dopant concentration preferably ranging from $1*10^{19}$ ions/cm$^3$ to $1*10^{21}$ ions/cm$^3$, and more preferably from $5*10^{19}$ ions/cm$^3$ to $5*10^{20}$ ions/cm$^3$ (such as about $1*10^{20}$ ions/cm$^3$). In this way, it is ensured that the contacts with the metallizations **192$_S$, 192$_D$** are low-resistance, non-rectifying (i.e., ohmic) contacts.

Referring to **Figure 2** together with the **Figure 1,** there is shown an exemplary diagram **200** representing the breakdown voltage (BV) at the gate-source (or drain) terminals depending on the depth d4 (with the depth **d1** equal to 3$\mu$m).

The diagram **200** has the breakdown voltage **BV** on the axis of the ordinates and the depth **d4** on the axis of abscissas. As it can be noted, the breakdown voltage **BV** has a constant value **BVc** (about 43 V) when the depth **d4** ranges from 0 to 0.6$\mu$m. Then, the breakdown voltage **BV** linearly increases up to reach a saturation breakdown voltage **BVs** (about 62 V) when the external portion **180a** extends to a depth d4 of about 1.8$\mu$m. For depths **d4** higher than 1.8$\mu$m, the breakdown voltage **BV** remains approximately constant and equal to the saturation breakdown voltage **BVs.** Therefore, in order to reach the maximum allowable breakdown voltage **BV,** the depth **d4** should be at least equal to 1.8$\mu$m. However, it is preferable not to exceed this value; indeed, any increase of the depth **d4** has no effect on the breakdown voltage **BV** but it reduces the saturation current of the MOS transistor **100.**

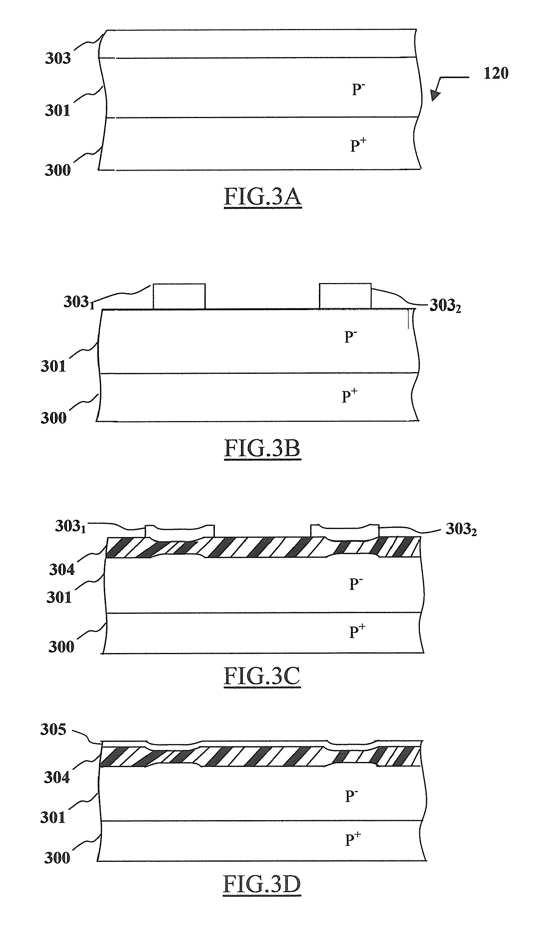

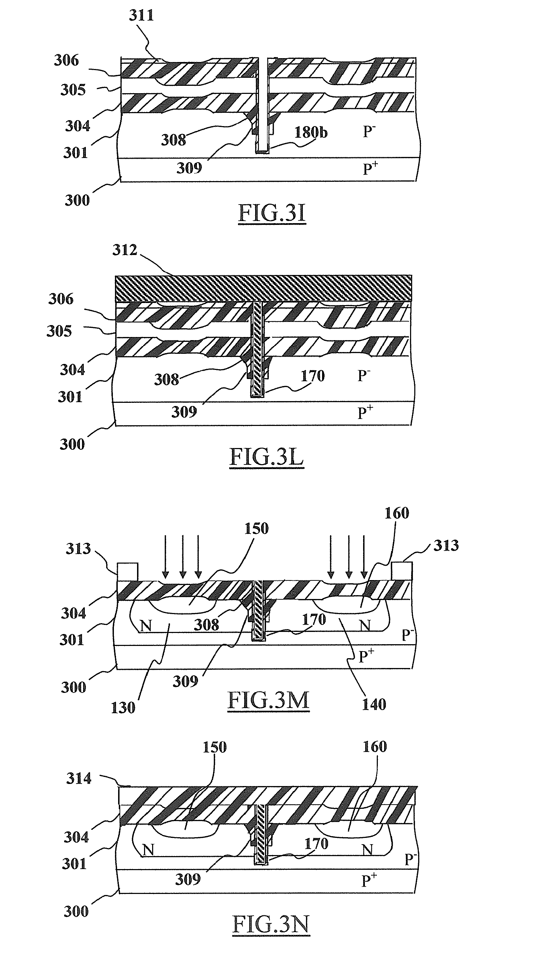

Referring now to **Figures 3A** through **3N,** a process for the manufacturing of the MOS transistor according to an embodiment of the present invention will be explained in detail.

Considering in particular **Figure 3A,** the starting material is a semiconductor substrate **300** (for example, the silicon wafer substrate) of the P type of conductivity with a dopant concentration ranging from approximately $5*10^{18}$ ions/cm$^3$ to approximately $5*10^{19}$ ions/cm$^3$. A less doped layer **301** (of the P- type) is epitaxially grown over it; for example, the epitaxial layer **301** may have a dopant concentration ranging from approximately $5*10^{14}$ ions/cm$^3$ to approximately $5*10^{15}$ ions/cm$^3$ and a thickness of about 10μm. Successively, a silicon nitride film **303,** with a thickness of about 100 nm, is deposited on top of the epitaxial layer 301, for example, by means of a CVD (acronym for Chemical Vapor Deposition) process.

Thereafter, the silicon nitride film **303** is selectively etched and removed, using a conventional photoetching process, as shown in Figure **3B.** As a result, two silicon nitride film portions **303$_1$** and **303$_2$** are left, covering the epitaxial layer 301.

Moving to **Figure 3C,** the wafer is then subjected to a thermal oxidation treatment, whereby a (field) oxide layer **304** is grown. This technique (known as LOCOS) allows obtaining regions that are thinner where the epitaxial layer **301** is covered by the silicon nitride film portions **303$_1$** and **303$_2$.** In alternative, the same result may be obtained by other techniques, such as the STI (acronym for Shallow Trench Isolation) and Recessed LOCOS techniques.

As shown in **Figure 3D,** after the removal of the nitride film portions **303$_1$** and **303$_2$,** a further silicon nitride film **305** is formed over the structure surface, *e.g.,* by a CVD process.

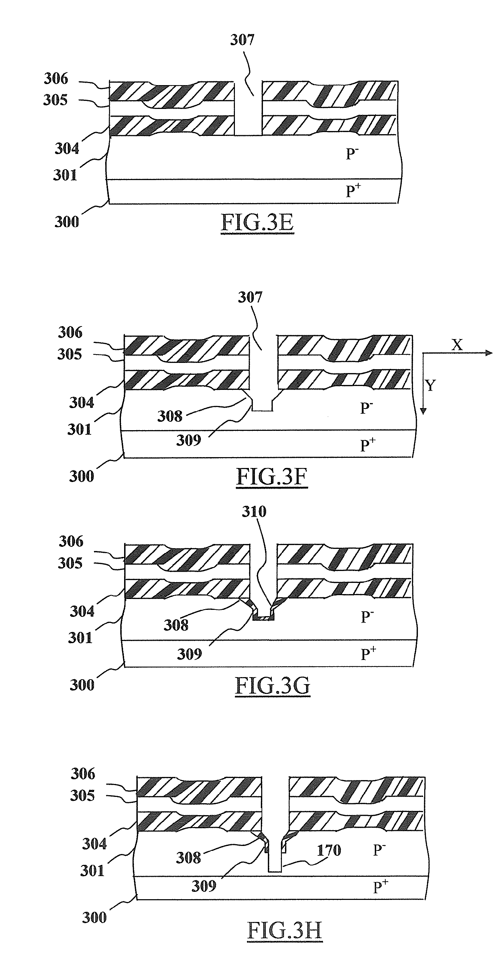

Moving to **Figure 3E,** an oxide layer **306** is then formed (e.g., deposited) on top of the silicon nitride film **305.** A first trench portion **307** is then formed, by selectively etching the layers **304, 305** and **306.** In order to form the first trench portion **307,** a photoresist mask (not shown in the figure) is provided on the oxide layer **306,** so as to leave exposed an area of the layer **306** where the first trench portion **307** is to be formed. Using suitable etching techniques, the layers **306, 305** and **304** are selectively removed, down to the surface of the epitaxial layer **301.**

Thereafter, the first trench portion **307** is extended down to the depth d4 (for example, 1.5μm) by selectively etching the silicon layer **301,** with the layers **304, 305** and **306** used as a hard mask, as shown in **Figure 3F.** In such a way, the first trench portion **307** is adapted to accommodate the external portion of the insulation layer (for the trench gate).

The etching is performed by two processes, each one having a corresponding isotropic degree with respect to two directions **X** (lateral) and **Y** (vertical).

More in detail, the isotropic degree (in the following referred to also as AD) is defined through the following expression:

$$AD = x/y$$

wherein y is the etching depth along the direction **Y** and x is the etching depth along the direction **X.**

In particular, the first etching has an isotropic degree preferably equal to 90% - 100%, and more preferably equal to 95% - 100%, such as about 100% (meaning that the epitaxial layer **301** is equally etched laterally and vertically so as to form a sloped portion **308** adapted to accommodate the edge section of the insulation layer). In other words, the sloped portion **308** generates an undercut below the oxide layer **304.**

The second etching has instead an isotropic degree theoretically equal to about 0, such as lower than 5% and more preferably lower than 2% (meaning that the epitaxial layer **301** is only vertically etched so as to form a straight portion **309** adapted to accommodate the remaining section of the insulation layer).

Then, a thermal oxidation should be performed for growing the desired insulation layer. However, the preceding etching process may affect the quality of the oxide that will be subsequently grown on the walls of the trench portions **308** and **309.** In order to avoid this problem, the wafer is now subjected to a thermal annealing process into a room providing an environment saturated with hydrogen (H2), at an annealing temperature preferably ranging from 900°C to 1100°C, and more preferably from 950°C to 1050°C (for example, 1000°C). During this phase, the wafer is heated by means of a thermal process (for example, by means of Rapid Thermal Process) up to the annealing temperature and subsequently cooled in the same room (including H2 only). In such a way, the thermal annealing process allows the silicon molecules belonging to the walls of the trench portions **308** and **309** to arrange along their preferential directions, so resolving the above mentioned problem (without requiring any further etching of the epitaxial layer **301** or rioxidation of the silicon).

A thermal oxidation is now performed for growing a first oxide layer **310** on the walls of the trench portions **308** and **309,** as shown in **Figure 3G.** As described in detail in the following, the first oxide layer **310** has a thicknesses depending on the difference between the thicknesses of the external portion and of the internal portion of the insulation layer for the trench gate. Thereafter, the first oxide layer 310 is selectively etched by using a suitable self-aligned process having a very low isotropic degree (for example, at most 2%). In such a way, the portion of the first oxide layer **310** covering the bottom of the portion **309** is totally removed. However, even though the etching process is strongly anisotropic (i.e., with a very low isotropic degree), a thin portion of the first oxide layer **310** is also removed from the lateral walls of the trench portion **308,** and in particular from the portion of the walls being near the main surface of the wafer. However, this is not a problem since the sloped edge portion **308** in any case allows the first oxide layer **310** to reach the desired thickness (since before the etching process such thickness is slightly greater than the desired one). Thereafter, as shown in Figure 3H, the silicon layer 301 is further etched down to the depth **d1** so forming the trench **170,** with the layers **304, 305, 306** and **310** used as a mask. In the example at issue, the resulting trench 170 has a depth equal to 3.6μm.

As described in the foregoing, also these etching process may affect the quality of the oxide which will be subsequently formed on the walls of the trench **170.** In order to avoid this problem, the wafer is subjected to a further thermal annealing process with similar operative parameters as in the preceding case. In such a way, the quality of a subsequent grown oxide or of an interface with a subsequent deposited oxide will be improved for the desired purpose.

Moving to **Figure 3I,** a second oxide layer **311** is deposed, for example, by means of a CVD process. The second oxide layer **311** has a thickness corresponding to the one of the internal portion of the insulation layer of the trench gate (90 nm, in the example at issue). In this case, the thickness of the first oxide layer **310** is exactly the same as the difference between the thicknesses of the external portion and of the internal portion (260 nm, in the example at issue). The second oxide layer **311** covers the entire surface of the wafer, including the lateral and bottom walls of the trench **170.**

It should be noted that, thanks to the preceding annealing steps, it is possible to obtain an insulation layer with a quite uniform thickness even along the curvature near the bottom wall of the trench **170;** for example, this thickness is 15%-30% greater than the one that would have been obtained without the annealing steps.

Alternatively, in order to form the internal portion of the insulation layer of the trench gate, the second oxide layer can be thermally grown along the walls of the trench **170.** In this case, however, the thickness of the second oxide layer where the trench **170** is already covered by the first oxide layer **310** is lower than the one where the trench **170** is completely exposed; more specifically the thickness of the second oxide layer depends non-linearly (for example, according to a square root law) on the thickness of the first oxide layer **310.** Moreover, the first oxide layer **310** can be subjected to a certain numbers of surface treatments that reduce its thickness before the growing of the second oxide layer. For these reasons, the thickness of the first oxide layer **310** must be higher than the difference between the thicknesses of the external portion and of the internal portion of the insulating layer for the trench gate (for example, 350 nm in the example at issue).

Thereafter, as shown in **Figure 3L,** a polycrystalline silicon layer **312** is formed by the CVD process over the wafer, at the same time filling the trench **170.** Considering now **Figure 3M,** the above described layers are removed down to the surface of the field oxide layer **304.** An implant mask **313** is then formed on the oxide layer **304** (for the subsequent dopant implantation processes).

A first dopant implantation process is performed, for forming the internal source and drain regions **130** and **140;** for example, in order to form N-type source and drain regions, arsenic or phosphorus dopant ions may be used.

Particularly, the first implantation process is performed at a relatively high energy, for example up to 2 or 3 MeV, in order to cause the dopant ions to penetrate the field oxide layer **304** and the epitaxial layer **301,** down to the depth **d2** (whereas where the mask **313** is present the dopants do not reach the surface of the epitaxial layer **301).**

Preferably, the dopants, after having been implanted, are simply activated by means of a high thermal budget Rapid Thermal Process (RTP), without being made to diffuse into the epitaxial layer.

Alternatively, the source and drain regions may be graded doped junctions. In this case it is possible to perform more than one dopant implantation process, at different, relatively high energies, for example, 200 keV, 400 KeV, 1000 keV and 2500 keV.

Successively, still using the mask **313,** a second dopant implantation process is performed in order to form the heavily doped contact regions **150** and **160** of the N-type. In particular, the second dopant implantation process is performed at an energy sufficiently high to cause the dopants to penetrate the thinner portions of the field oxide layer **304,** but too low to cause the dopants to penetrate the thicker portions of the field oxide layer **304.** For example, arsenic ions are implanted at an energy of approximately 50KeV, adapted to concentrate the dopant distribution close to the surface of the wafer.

Thereafter, as shown in **Figure 3N,** a silicon oxide layer **314** is deposited over the field oxide layer **304,** for example, by means of a CVD process. For realizing the drain, source and gate contacts, windows are etched through the oxide layers 314 and **304,** down to the surface of the contact regions **150** and **160.**

Afterwards, a metallization layer, (for example, A1 or Ti/TiN plus a W-plug and an A1 layer) is deposited on the oxide layer **314,** and the source, drain and gate contacts are formed by patterning thereof, so as to obtain the structure described above with reference to **Figure 1.**

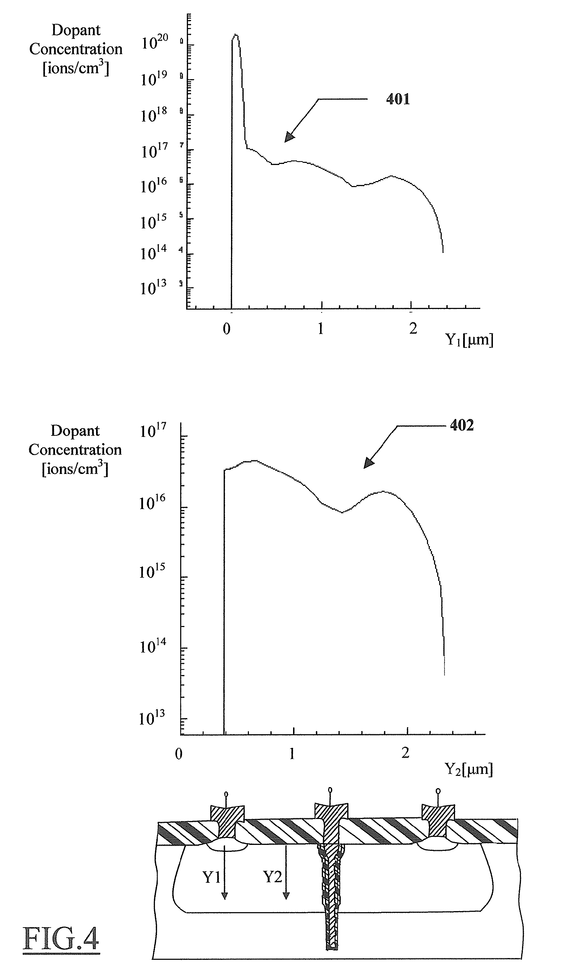

In **Figure 4,** there are shown exemplary profiles **401** and **402** of the dopant concentrations of the drain/source regions of the MOS transistor **100** along the axis $Y_1$ and $Y_2$, respectively.

In particular, the profile **401** shows the dopant concentration of the region under the drain/source terminals, while the profile **402** shows the dopant concentration of the regions under the field oxide layer.

Both the profiles are chosen in order to optimise a number of transistor parameters, such as the current capability, the on-resistance, the safe operating area (SOA) and the breakdown voltages at the PN junctions, as better described in the following.

In particular, referring to the profile **401,** the dopant concentration of the regions closer to the surface of the structure is higher than that in the deeper regions. This allows realizing the ohmic contacts of the MOS transistor. Moreover, the lower dopant concentration of the deeper regions allows increasing the breakdown voltage of the MOS transistor.

Moving now to the profile **402,** it should be noted that the dopant concentration of the regions under the field oxide layer is always lower than the dopant concentration of the drain/source contact regions. Also this choice allows increasing the breakdown voltage.

In this way, it is possible to obtain a MOS transistor capable of withstanding voltages ranging from 50 to 60V, having a pitch lower than 3.5$\mu$m, whereas conventional horizontal-gate structures are capable of withstanding the same voltages but with a pitch of about 11.5$\mu$m.

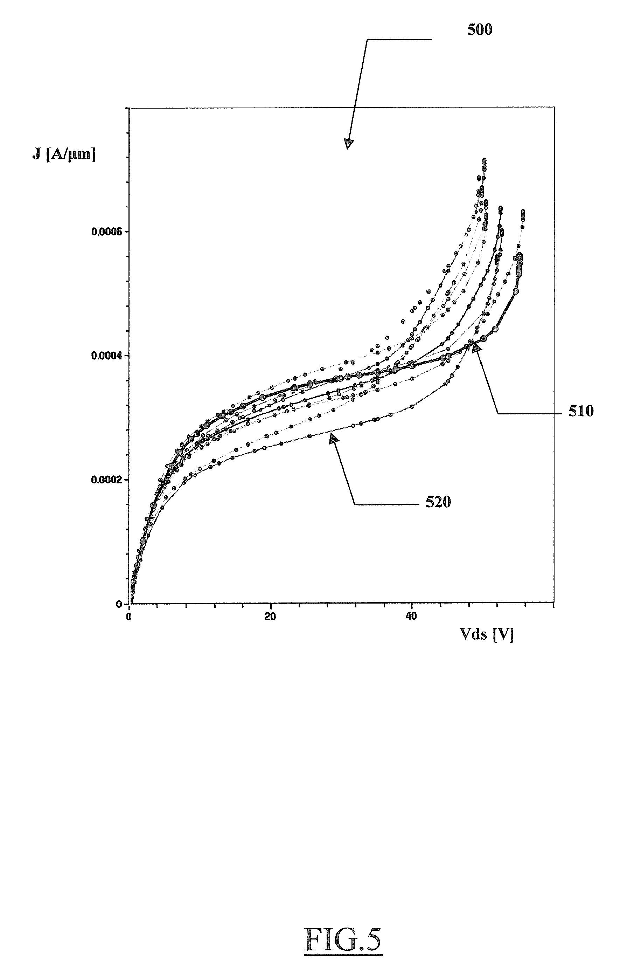

Referring to **Figure 5,** a diagram **500** shows a set of working characteristics of the MOS transistor depending on the dopant concentration of the operative internal source and drain regions. In particular, the diagram **500** has a current density **J**[A/$\mu$m] on the axis of ordinates, and a biasing voltage **Vds**[V] at the MOS transistor *(i.e.,* the voltage applied between the drain terminal and the source terminal) on the axis of the abscissas.

As can be seen, a working characteristic **510** is obtained for a MOS transistor having the profiles of the dopant concentration of the drain and source regions shown in **Figure 4.** The remaining working characteristics are obtained for non-optimised MOS transistors having different profiles of the dopant concentrations.

As it can be noted, the working characteristic **510** has a saturation current density **J** ranging from 350$\mu$A/$\mu$m to 450$\mu$A/$\mu$m and a breakdown voltage about 55V. Both values are higher than the saturation current density and the breakdown voltage of the other working characteristics (for example, the working characteristic **520** has a saturation current density ranging from 250$\mu$A/$\mu$m to 350$\mu$A/$\mu$m and a breakdown voltage about 40V).

Thus, by choosing the dopant concentration of the drain and source regions *(i.e.,* the energy for the implantation processes) it is possible to optimise the trade-off between the saturation current density **J** flowing in the MOS transistor and the voltage which is withstood by the transistor.

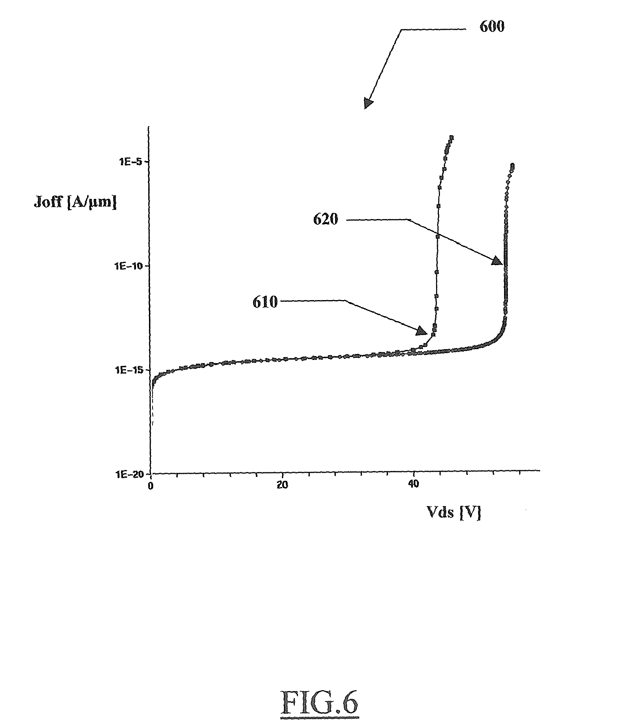

Finally, in **Figure 6** there is provided a diagram **600** having a quenching current density **Joff** [A/pm] on the axis of ordinates, and the value of the biasing voltage **Vds** [V] at the MOS transistor on the axis of the abscissas. The diagram **600** shows two curves **610** and **620.** The first one (curve **610)** is obtained for a conventional MOS transistor having a single oxide layer with a thin thickness adapted for being the gate oxide. The second one (curve **620)** is obtained for the MOS transistor that, as described in an embodiment of the present invention, has the insulation layer having a differentiated thickness. As it can be noted, exploiting the above described structure, it is possible to obtain a MOS transistor capable of sustaining voltages ranging from 50 to 60V (curve **620).**

Naturally, in order to satisfy local and specific requirements, a person skilled in the art may apply to the solution described above many modifications and alterations. Particularly, although the present invention has been described with a certain degree of particularity with reference to preferred embodiments thereof, it should be understood that various omissions, substitutions and changes in the form and details as well as other embodiments are possible; moreover, it is expressly intended that specific elements and/or method steps described in connection with any disclosed embodiment of the invention may be incorporated in any other embodiment as a general matter of design choice.

For example, although in the preceding description reference has been made to an N channel MOS transistor, the conductivity types of the various regions may be reversed, so as to form a P-channel MOS transistor.

In addition, the external portion of the insulation layer might also reach the channel of the MOS transistor (even if its performance would be reduced).

In any case, a different extension of the external portion of the insulation layer (with respect to the depth of the drain/source regions) is contemplated.

It should be noted that the proposed thicknesses of the different portions of the insulation layer must not be interpreted in a limitative manner.

Moreover, the solution of the invention is also suitable to be implemented in MOS transistors having one only between the source and drain regions adjacent to the insulated trench gate (while the other region is buried under the channel).

In addition, it is possible to use other profiles of the dopant concentrations.

In any case, the use of alternative processes for realizing the proposed MOS transistor are possible.

For example, it is not necessary to grow the epitaxial layer or to form the silicon nitride layer.

Alternatively, both the first oxide layer and the second oxide layer can be formed by means of deposition processes.

In addition, the drain and source regions may be formed in another way, (e.g., by means of an epitaxial growth), or the insulated trench gate may be formed by using a metal material instead of polycrystalline silicon.

In addition, it is also possible to manufacture the vertical-gate MOS transistor easily in a structure also including standard horizontally-channel MOS transistors (with the channel region developing horizontally between the drain and source regions).

Moreover, the (sloped) edge section of the trench may extend at a different angle and can have a different shape; alternatively, the same result may also be achieved with another isotropic degree of etching, or with equivalent techniques. In any case, the implementation of the MOS transistor with a trench that is completely vertical (i.e., without any sloped edge section) is not excluded in some applications.

Similar considerations apply if the steps of annealing are carried out at different temperatures and/or in another environment. In any case, those steps are not strictly necessary and may be omitted (at the cost of a degradation of the performance of the MOS transistor).

## Claims

1. A vertical-gate MOS transistor **(100)** integrated in a semiconductor chip **(120)** of a first conductivity type having a main surface, the vertical-gate MOS transistor including:

   an insulated trench gate **(110)** extending into the semiconductor chip from the main surface to a gate depth **(d1),** said trench gate including a control gate **(G)** and an insulation layer **(180)** for insulating the control gate from the semiconductor chip,
   a source region and a drain region of a second conductivity type formed in the semiconductor chip, at least one of the source region and drain region being adjacent to the insulation layer and extending into the semiconductor chip from the main surface to a region depth (d2) lower than the gate depth,

   **characterized in that**
   the insulation layer includes an external portion **(180a),** extending into the semiconductor chip from the main surface to a protection depth (**d4**) lower than the gate depth, and a remaining internal portion **(180b),** the external portion having an external thickness **(d5)** and the internal portion having an internal thickness **(d6)** lower than the external thickness.

2. The vertical-gate MOS transistor **(100)** according to claim 1, wherein the protection depth **(d4)** is lower than the region depth **(d2).**

3. The vertical-gate MOS transistor **(100)** according to claim 2, wherein the protection depth **(d4)** ranges from 20% to 60% of the gate depth **(d1).**

4. The vertical-gate MOS transistor **(100)** according to any one of the preceding claims, wherein the internal thickness **(d6)** ranges from 15% to 40% of the external thickness **(d5).**

5. The vertical-gate MOS transistor **(100)** according to any one of the preceding claims, wherein each one of the source region and drain region is adjacent to the insulation layer **(180)** and extends into the semiconductor chip (120) from the main surface to the region depth **(d2).**

6. The vertical-gate MOS transistor **(100)** according to claim 5, wherein each one of the source region and drain region includes a contact external region (150, 160) extending from the main surface at a non-zero distance from the trench gate and a remaining operative internal region **(130,140),** the internal region having an internal dopant concentration and the external region having an external dopant concentration higher than the internal dopant concentration.

7. The vertical-gate MOS transistor **(100)** according to claim 6, wherein the external dopant concentration ranges from $10^2$ to $10^6$ times the internal dopant concentration.

8. The vertical-gate MOS transistor **(100)** according to claim 7, wherein the external dopant concentration ranges from $1*10^{19}$ ions/cm$^3$ to $1 * 10^{21}$ ions/cm$^3$, and the internal dopant concentration ranges from $1*10^{15}$ ions/cm$^3$ to $1*10^{17}$ ions/cm$^3$.

9. A method for manufacturing a vertical-gate MOS transistor **(100)** integrated in a semiconductor chip **(120)** of a first conductivity type having a main surface, the method including the steps of:

   forming an insulated trench gate **(170)** extending into the semiconductor chip from the main surface to a gate depth **(d1),** the step of forming the trench gate including forming a control gate **(G)** and forming an insulation layer **(180)** for insulating the control gate from the semiconductor chip,
   and forming a source region and a drain region of a second conductivity type in the semiconductor chip, at least one of the source region and drain region being adjacent to the insulation layer and extending into the semiconductor chip from the main surface to a region depth **(d2)** lower than the gate depth,

   **characterized in that**
   the step of forming the insulation layer includes

   forming an external portion **(180a),** extending into the semiconductor chip from the main surface to a protection depth **(d4)** lower than the gate depth **(d1),** and a remaining internal portion **(180b),** the external portion having an external thickness **(d5)** and the internal portion having an internal thickness **(d6)** lower than the external thickness.

10. The method according to claim 9, wherein the protection depth **(d4)** is lower than the region depth **(d2).**

11. The method according to claim 10, wherein the protection depth **(d4)** ranges from 20% to 60% of the gate depth **(d1).**

12. The method according to any claim from 9 to 11, wherein the internal thickness **(d6)** ranges from 15% to 40% of the external thickness **(d5).**

13. The method according to any claim from 9 to 12, wherein each one of the source region and drain region is adjacent to the insulation layer **(180)** and extends into the semiconductor chip from the main surface to the region depth **(d2).**

14. The method according to claim 13, wherein the step of forming the source region and the drain region includes forming, for each one of the source region and drain region, a contact external region **(150,160)** extending from the main surface at a non-zero distance from the trench gate and a remaining operative internal region **(130,140),** the internal region having an internal dopant concentration and the external region having an external dopant concentration higher than the internal dopant concentration.

15. The method according to claim 14, wherein the external dopant concentration ranges from $10^2$ to $10^6$ times the internal dopant concentration.

16. The method according to claim 15, wherein the external dopant concentration ranges from $1*10^{19}$ ions/cm$^3$ to $1*10^{21}$ ions/cm$^3$, and the internal dopant concentration ranges from $1*10^{15}$ ions/cm$^3$ to $1*10^{17}$ ions/cm$^3$.

17. The method according to any claim from 9 to 16, wherein the step of forming the insulated trench gate includes:

    forming a trench extending into the semiconductor chip **(120)** from the main surface to the protection depth **(d4);**
    forming a first oxide layer in the trench;
    etching a bottom wall of the first oxide layer;
    extending the trench to the gate depth **(d1);** and
    forming a second oxide layer in the trench.

18. The method according to claim 17, wherein the step of forming the first oxide layer includes growing the first oxide layer, and wherein the step of forming the second oxide layer includes deposing or growing the second oxide layer.

19. The method according to claim 17 or 18, wherein the step of forming the trench includes performing a first etching to form an edge section **(180c)** of a lateral wall of the trench extending from the main surface and being inclined outwardly with respect to a remaining prevalent section of the lateral wall, and a second etching to form said prevalent section, the first etching having a first isotropic degree, defined by the ratio between a lateral etching depth along a direction parallel to the main surface and a vertical etching depth along a direction perpendicular to the main surface, and the second etching having a second isotropic degree lower than the first isotropic degree.

20. The method according to claim 19, wherein the edge section **(180c)** is inclined at an angle ranging from 30° to 45°.

21. The method according to claim 19 or 20, wherein the edge section **(180c)** extends at an edge depth from the main surface ranging from 10% to 20% of the protection depth **(d4).**

22. The method according to any claim from 19 to 21, wherein the first isotropic degree ranges from 90% to 100% and the second isotropic degree is substantially zero.

23. The method according to any claim from 17 to 22, wherein the step of forming the insulated trench gate further includes:

    annealing the trench before forming the first oxide layer.

24. The method according to any claim from 17 to 23, wherein the step of forming the insulated trench gate further includes:

    annealing the extended trench before forming the second oxide layer.

25. The method according to claim 23 or 24, wherein each step of annealing includes:

    eating the semiconductor chip **(120)** at a temperature ranging from 900°C to 1100°C.

26. The method according to any claim from 23 to 25, wherein each step of annealing is performed in an environment saturated with hydrogen.

EP 1 786 031 A1

FIG.1

EP 1 786 031 A1

200

FIG.2

303

P⁻ ──→ 120

301

300

P⁺

FIG.3A

303₁ ──── 303₂

301

P⁻

300

P⁺

FIG.3B

303₁ ──── 303₂

304

301

P⁻

300

P⁺

FIG.3C

305

304

301

P⁻

300

P⁺

FIG.3D

FIG.3E

FIG.3F

FIG.3G

FIG.3H

311

306
305
304
301

308        180b        P⁻

309        P⁺

300

FIG.3I

312

306
305
304
301

308        170        P⁻

309        P⁺

300

FIG.3L

150        160

313                        313

304
301

N        308        170        N        P⁻

300                        P⁺

130        309        FIG.3M        140

150        160

314

304
301

N        170        N        P⁻

309        P⁺

300

FIG.3N

FIG.4

FIG.5

FIG.6

## EUROPEAN SEARCH REPORT

**European Patent Office**

**Application Number**

EP 05 11 0577

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2003/162358 A1 (HANAFI HUSSEIN I ET AL) 28 August 2003 (2003-08-28) | 1-22 | H01L21/336 |
| Y | * paragraph [0037] - paragraph [0041]; figures 3-13 * | 23-26 | H01L29/78 H01L29/423 H01L21/28 |
| Y | BULLIS W M: "Current trends in silicon defect technology" MATERIALS SCIENCE AND ENGINEERING B, ELSEVIER SEQUOIA, LAUSANNE, CH, vol. 72, no. 2-3, March 2000 (2000-03), pages 93-98, XP004192066 ISSN: 0921-5107 * abstract * * page 94, right-hand column, line 31 - line 32 * | 23-26 | |
| X | US 5 270 257 A (SHIN ET AL) 14 December 1993 (1993-12-14) * figures 3a-3e * | 1,5,6,9, 13,14 | |
| X | US 5 814 544 A (HUANG ET AL) 29 September 1998 (1998-09-29) * figures 1-3 * | 1,5,6,9, 13,14 | **TECHNICAL FIELDS SEARCHED (IPC)** H01L |
| A | US 2005/090066 A1 (ZHU HUILONG ET AL) 28 April 2005 (2005-04-28) * figure 3 * | 1-26 | |

The present search report has been drawn up for all claims

| Place of search | Date of completion of the search | Examiner |
|---|---|---|
| Munich | 23 March 2006 | Nesso, S |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 786 031 A1**

## ANNEX TO THE EUROPEAN SEARCH REPORT
## ON EUROPEAN PATENT APPLICATION NO.

EP 05 11 0577

This annex lists the patent family members relating to the patent documents cited in the above-mentioned European search report.
The members are as contained in the European Patent Office EDP file on
The European Patent Office is in no way liable for these particulars which are merely given for the purpose of information.

23-03-2006

| Patent document cited in search report | | Publication date | Patent family member(s) | | Publication date |
|---|---|---|---|---|---|
| US 2003162358 | A1 | 28-08-2003 | US | 2003211681 A1 | 13-11-2003 |
| US 5270257 | A | 14-12-1993 | DE | 4212829 A1 | 19-11-1992 |
| | | | JP | 2826924 B2 | 18-11-1998 |
| | | | JP | 5109758 A | 30-04-1993 |
| | | | KR | 9402400 B1 | 24-03-1994 |
| US 5814544 | A | 29-09-1998 | NONE | | |
| US 2005090066 | A1 | 28-04-2005 | CN | 1624885 A | 08-06-2005 |

EPO FORM P0459

For more details about this annex : see Official Journal of the European Patent Office, No. 12/82

19

**REFERENCES CITED IN THE DESCRIPTION**

**Patent documents cited in the description**

- US 4455740 A
- US 6586800 B
- US 5124764 A